# EUROPEAN PATENT APPLICATION

(11) **EP 4 700 822 A1**
(43) Date of publication of application: **25.02.2026**
(21) Application number: 24792333.7
(22) Date of filing: 07.02.2024
(51) Int. Cl.: H01L 21/31, B01D 53/68, B01D 53/70

(54) **CONTROL DEVICE AND CONTROL METHOD FOR EXHAUST GAS TREATMENT SYSTEM**

(30) Priority: 19.04.2023 JP 2023068638
(71) Applicant: EBARA CORPORATION, Ota-ku, Tokyo 144-8510 (JP)
(72) Inventor: OCHIAI, Toshiharu, Tokyo 144-8510 (JP); FUKUSHIMA, Yuya, Tokyo 144-8510 (JP)
(74) Representative: Carstens, Dirk Wilhelm
(86) International application number: PCT/JP2024/004140
(87) International publication number: WO 2024/219057

(57) **Abstract**

The present invention relates to a controller and a controlling method for controlling an operation of an exhaust gas treatment system having multiple treatment apparatuses. The controller (6) for controlling an operation of the exhaust gas treatment system (1) having the multiple treatment apparatuses (2A to 2C), the controller (6) includes: multiple sub-controllers (8A to 8C) corresponding to the multiple treatment apparatuses (2A to 2C) and configured to individually control operations of the multiple treatment apparatuses (2A to 2C); and a main controller (7) electrically coupled to the multiple sub-controllers (8A to 8C), wherein the main controller (7) includes: a power source (10) configured to supply power to the multiple sub-controllers (8A to 8C); and a comprehensive controller (11) configured to comprehensively control the operations of the multiple treatment apparatuses (8A to 8C), and each of the multiple sub-controllers (8A to 8C) includes an individual controller (13) electrically coupled to a device (3, 4) configured to operate a corresponding treatment apparatus (2A, 2B, or 2C).

## Description

### Technical Field

The present invention relates to a controller and a controlling method for controlling an operation of an exhaust gas treatment system having multiple treatment apparatuses.

### Background Art

In a semiconductor manufacturing process of manufacturing semiconductor devices, liquid crystal panels, LEDs, or the like, a process gas is introduced into a process chamber to perform various processes, such as an etching process, a CVD process or the like, while the process chamber is evacuated. The process chamber and exhaust apparatuses coupled to the process chamber are cleaned periodically by supplying a cleaning gas thereto. Because exhaust gases, such as the process gas and the cleaning gas, contain a silane-based gas, a halogen gas, a PFC gas or the like, such exhaust gases have negative effects on the human body and on the global environment, such as global warming. Therefore, it is not preferable that these exhaust gases are emitted to the atmosphere as they are. Thus, these exhaust gases are made harmless by an exhaust gas treatment system provided at a downstream side of the semiconductor processing apparatus, so that the harmless exhaust gases are emitted to the atmosphere.

### Citation List

### Patent Literature

Patent document 1: Japanese laid-open patent publication No. 2008-161861

### Summary of Invention

### Technical Problem

With a recent trend toward larger semiconductor wafers, an amount of the exhaust gas discharged from the semiconductor processing apparatus has been increasing. In order to efficiently treat the increased exhaust gas, an exhaust gas treatment system having multiple treatment apparatuses has been used. The exhaust gas treatment system having the multiple treatment apparatuses has a backup function for switching to a spare treatment apparatus to continue operation of the exhaust gas treatment system when an abnormality occurs in one treatment apparatus.

A conventional exhaust gas treatment system having multiple treatment apparatuses is configured to control the multiple treatment apparatuses by a single controller. Therefore, it is required to change specifications of the controller and control circuits every time the number of treatment apparatuses is increased or decreased. Furthermore, in order to ensure a safe operation of the exhaust gas treatment system, the controller includes an interlock system configured to stop operations of the treatment apparatuses when various sensors, such as a temperature sensor and a water leak sensor, detect an abnormality in the treatment apparatus. The controller requires a configuration of the interlock system to be changed every time the number of treatment apparatuses is increased or decreased. For these reasons, there has been a problem that the configuration of the controller cannot be standardized.

Therefore, the present invention provides a controller and a controlling method capable of achieving standardization of the controller configured to control an operation of an exhaust gas treatment system having multiple treatment apparatuses.

### Solution to Problem

In an embodiment, there is provided a controller for controlling an operation of an exhaust gas treatment system having multiple treatment apparatuses, the controller comprising: multiple sub-controllers corresponding to the multiple treatment apparatuses and configured to individually control operations of the multiple treatment apparatuses; and a main controller electrically coupled to the multiple sub-controllers, wherein the main controller includes: a power source configured to supply power to the multiple sub-controllers; and a comprehensive controller configured to comprehensively control the operations of the multiple treatment apparatuses, and each of the multiple sub-controllers includes an individual controller electrically coupled to a device configured to operate a corresponding treatment apparatus.

In an embodiment, the device comprises an operating valve coupled to the corresponding treatment apparatus.

In an embodiment, the device comprises an operating sensor configured to detect a physical quantity from the corresponding treatment apparatus and output a signal representing the physical quantity.

In an embodiment, each of the multiple sub-controllers further includes an interlock system configured to perform an interlock operation for closing an emergency shut-off valve when an abnormality occurs in at least one treatment apparatus of the multiple treatment apparatuses, the emergency shut-off valve being coupled to the treatment apparatus in which the abnormality has occurred, the interlock system is electrically coupled to the emergency shut-off valve, and an interlock sensor provided at the at least one treatment apparatus, and the interlock system is configured to close the emergency shut-off valve when the interlock sensor detects that the abnormality has occurred in the at least one treatment apparatus.

In an embodiment, the individual controller is electrically coupled to the emergency shut-off valve via the interlock system, the emergency shut-off valve is configured to be closed when an electrical connection between the individual controller and the emergency shut-off valve is shut off, the interlock system includes an individual relay switch disposed between the individual controller and the emergency shut-off valve, and the individual relay switch is configured to shut off the electrical connection between the individual controller and the emergency shut-off valve when the interlock sensor detects that the abnormality has occurred in the at least one treatment apparatus.

In an embodiment, the controller further includes an interlock synchronization line that electrically couples the multiple sub-controllers to each other, the interlock system further includes a switching device capable of being electrically coupled to the interlock synchronization line and the individual relay switch, and the switching device is configured to switch an internal electrical path thereof to thereby be capable of switching between an independent interlock mode for closing only the emergency shut-off valve coupled to the treatment apparatus in which the abnormality has occurred, a linked interlock mode for closing emergency shut-off valves coupled to at least two treatment apparatuses of the multiple treatment apparatuses, and an interlock disabled mode for disabling the interlock operation.

In an embodiment, the main controller further includes a power-source relay switch coupled to the power source, each of the multiple sub-controllers includes an individual relay switch coupled to an interlock sensor provided at least one treatment apparatus of the multiple treatment apparatuses, the power-source relay switch is electrically coupled to the individual relay switch, and the power-source relay switch is configured to shut off supply of the electric power from the power source to the multiple sub-controllers to stop operations of the multiple treatment apparatuses when the interlock sensor detects that the abnormality has occurred in the at least one treatment apparatus.

In an embodiment, there is provided a controlling method of controlling an operation of an exhaust gas treatment system having multiple treatment apparatuses, the method comprising: individually controlling operations of the multiple treatment apparatuses by multiple sub-controllers corresponding to the multiple treatment apparatuses; supplying power to the multiple sub-controllers from a power source of a main controller electrically coupled to the multiple sub-controllers; and comprehensively controlling the operations of the multiple treatment apparatuses by the main controller.

In an embodiment, individually controlling the operations of the multiple treatment apparatuses comprises controlling operations of operating valves coupled to the corresponding treatment apparatuses.

In an embodiment, the controlling method further comprises: performing an interlock operation for closing an emergency shut-off valve by at least one sub-controller of the multiple sub-controllers when an interlock sensor detects that an abnormality has occurred in at least one treatment apparatus of the multiple treatment apparatuses, the emergency shut-off valve being coupled to the treatment apparatus in which the abnormality has occurred.

In an embodiment, the controlling method further comprises: switching an internal electrical path of the multiple sub-controllers to thereby switch between an independent interlock mode for closing only the emergency shut-off valve coupled to the treatment apparatus in which the abnormality has occurred, a linked interlock mode for closing emergency shut-off valves coupled to at least two treatment apparatuses of the multiple treatment apparatuses, and an interlock disabled mode for disabling the interlock operation.

In an embodiment, the controlling method further comprises: shutting off supply of the electric power from the power source to the multiple sub-controllers to stop operations of the multiple treatment apparatuses when the interlock sensor detects that an abnormality has occurred in at least one treatment apparatus of the multiple treatment apparatuses.

### Advantageous Effects of Invention

According to the present invention, the main controller has a configuration for comprehensively controlling the operations of the multiple treatment apparatuses. The configuration for individually controlling the operations of the multiple treatment apparatuses is included in the multiple sub-controllers corresponding to the multiple treatment apparatuses. Therefore, it is not required to change the configuration of the main controller when the number of treatment apparatuses is increased or decreased, so that standardization of the main controller can be achieved.

### Brief Description of Drawings

[FIG. 1] FIG. 1 is a diagram showing an embodiment of a controller configured to control an operation of an exhaust gas treatment system having multiple treatment apparatuses;
[FIG. 2] FIG. 2 is a diagram showing another embodiment of the controller including detailed configurations of interlock systems;
[FIG. 3] FIG. 3 is a diagram illustrating an example of internal electrical paths of switching devices in the controller shown in FIG. 2;
[FIG. 4] FIG. 4 is a diagram illustrating an example of the internal electrical paths of the switching devices in the controller shown in FIG. 2;
[FIG. 5] FIG. 5 is a table showing examples of interlock operations set by the internal electrical paths of the switching devices;
[FIG. 6] FIG. 6 is a diagram showing still another embodiment of the controller including the detailed configurations of the interlock systems;
[FIG. 7] FIG. 7 is a diagram illustrating another example of the internal electrical paths of the switching devices in the controller shown in FIG. 6; and
[FIG. 8] FIG. 8 is a table showing examples of the interlock operations set by the internal electrical paths of the switching devices.

### Description of Embodiments

Hereinafter, embodiments of the present invention will be described with reference to the drawings.

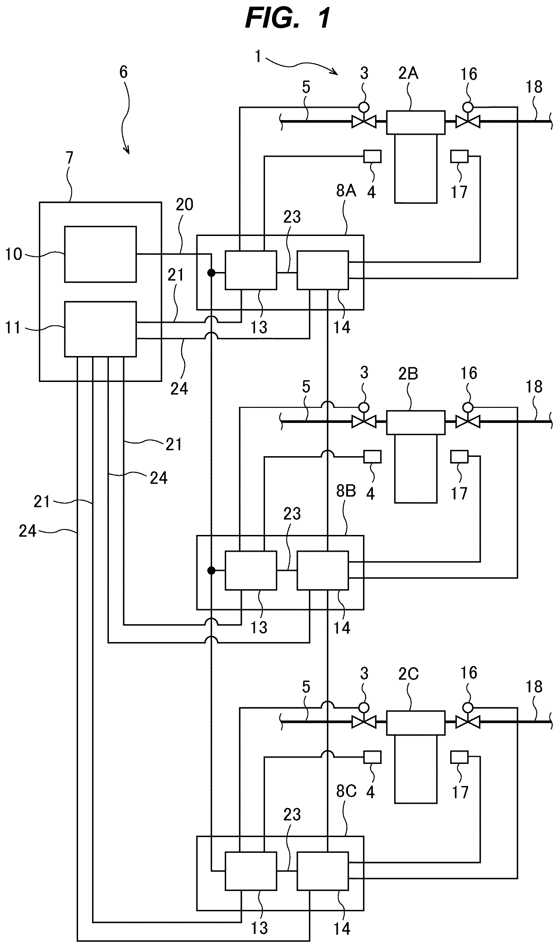

FIG. 1 is a diagram showing an embodiment of a controller 6 configured to control an operation of an exhaust gas treatment system 1 having multiple treatment apparatuses 2A to 2C. The exhaust gas treatment system 1 is configured to treat an exhaust gas discharged from a semiconductor processing apparatus to make the exhaust gas harmless. As shown in FIG. 1, the exhaust gas treatment system 1 has multiple (three in this embodiment) treatment apparatuses 2A to 2C. In this embodiment, the exhaust gas treatment system 1 has three treatment apparatuses 2A to 2C, but the number of treatment apparatuses is not limited to this embodiment. The exhaust gas treatment system 1 may have two treatment apparatuses, or four or more treatment apparatuses. Examples of the exhaust gas treatment system 1 include a combustion-type exhaust gas treatment system, a catalytic-type exhaust gas treatment system, a plasma-type exhaust gas treatment system, and a wet-type exhaust gas treatment system. In this case, examples of each of the multiple treatment apparatuses 2A to 2C include a combustion burner, a catalyst-filled container, a plasma generator, and a water treatment apparatus.

The exhaust gas treatment system 1 includes, as devices for operating the multiple treatment apparatuses 2A to 2C, operating valves 3 provided at the treatment apparatuses 2A to 2C, respectively, and operating sensors 4 provided at the treatment apparatuses 2A to 2C, respectively. The operating valves 3 are coupled to the treatment apparatuses 2A to 2C, respectively. The operating valves 3 are configured to open and close flow passages of multiple pipes 5 for supplying supply matter, such as fluid (e.g., exhaust gas, fuel, water, etc.), to corresponding treatment apparatuses 2A to 2C, respectively. The operating valves 3 are disposed in the pipes 5, respectively, through which the supply matter flows to the corresponding treatment apparatuses 2A to 2C. When the operating valves 3 are opened, the supply matter is supplied through the pipes 5 to the corresponding treatment apparatuses 2A to 2C.

The operating sensors 4 are configured to detect physical quantities in the corresponding treatment apparatuses 2A to 2C, respectively, and output signals representing the detected physical quantities, respectively. Examples of the operating sensors 4 include temperature sensors configured to measure temperatures of the treatment apparatuses 2A to 2C, flame detecting sensors configured to detect flames in the treatment apparatuses 2A to 2C, water leakage sensors configured to detect liquid leakage in the treatment apparatuses 2A to 2C, and gas detecting sensors configured to detect gas leakage in the treatment apparatuses 2A to 2C. In one embodiment, the exhaust gas treatment system 1 may include a plurality of operating valves 3 and a plurality of operating sensors 4 for each of the treatment apparatuses 2A to 2C. In one embodiment, the exhaust gas treatment system 1 may not include the operating sensor 4 for each of the treatment apparatuses 2A to 2C. For example, the treatment apparatus 2A may be provided with two operating valves 3 and a single operating sensor 4, and the treatment apparatuses 2B and 2C may each be provided with a single operating valve 3.

The exhaust gas treatment system 1 is coupled to the controller 6 configured to control the operation of the exhaust gas treatment system 1. The controller 6 includes a main controller 7 configured to comprehensively control operations of the multiple treatment apparatuses 2A to 2C, and multiple (three in this embodiment) sub-controllers 8A to 8C configured to individually control the operations of the multiple treatment apparatuses 2A to 2C. The sub-controllers 8A to 8C correspond to the treatment apparatuses 2A to 2C, respectively. Specifically, the sub-controller 8A corresponds to the treatment apparatus 2A, the sub-controller 8B corresponds to the treatment apparatus 2B, and the sub-controller 8C corresponds to the treatment apparatus 2C. The main controller 7 is electrically coupled to the multiple sub-controllers 8A to 8C. The main controller 7 includes a power source 10 configured to supply electric power to the multiple sub-controllers 8A to 8C, and a comprehensive controller 11 configured to comprehensively control the operations of the multiple treatment apparatuses 2A to 2C.

The multiple sub-controllers 8A to 8C are electrically coupled to the operating valves 3 and the operating sensors 4 provided at the corresponding treatment apparatuses 2A to 2C, respectively. Each of the multiple sub-controllers 8A to 8C has an individual controller 13 and an interlock system 14. Each individual controller 13 is electrically coupled to the operating valve 3 and the operating sensor 4. The individual controller 13 is configured to control an operation of the operating valves 3. The individual controller 13 is configured to obtain a signal representing a physical quantity of each treatment apparatus output from the operating sensor 4. In one embodiment, the individual controller 13 may be configured to control an operation of the operating valve 3 based on an instruction issued from the comprehensive controller 11.

The power source 10 of the main controller 7 is coupled to the individual controllers 13 of the sub-controllers 8A to 8C via a power supply line 20. The power generated by the power source 10 is transmitted to the individual controllers 13 of the sub-controllers 8A to 8C via the power supply line 20. The individual controllers 13 are coupled to the interlock systems 14 of the sub-controllers 8A to 8C via power supply lines 23, respectively. The electric power generated by the power source 10 is transmitted from the individual controllers 13 to the interlock systems 14 of the sub-controllers 8A to 8C via the power supply lines 23, respectively.

In one embodiment, each individual controller 13 is composed of at least one computer. Each individual controller 13 includes a memory (not shown) storing programs therein for controlling the operation of the operating valve 3, which is a corresponding device, and receiving signals from the operating sensor 4, which is a corresponding device, and an arithmetic device (not shown) configured to perform arithmetic operations according to instructions contained in the programs. The memory includes a main memory, such as a random-access memory (RAM), and an auxiliary memory, such as a hard disk drive (HDD) or a solid-state drive (SSD). Examples of the arithmetic device include a central processing unit (CPU) and a graphics processing unit (GPU). However, the specific configuration of the individual controller 13 is not limited to these examples. In one embodiment, each individual controller 13 is a programmable logic controller (PLC), or a control board using microcomputer chip(s), and may be configured to control the operation of the operating valve 3 based on signals input from outside via a not-shown input device (e.g., a keyboard and a mouse).

The comprehensive controller 11 of the main controller 7 is electrically coupled to the individual controllers 13 of the multiple sub-controllers 8A to 8C via communication lines 21, respectively. The comprehensive controller 11 is configured to comprehensively control the operations of the treatment apparatuses 2A to 2C via the individual controllers 13 of the sub-controllers 8A to 8C. Output signals from the operating sensors 4 are obtained by the individual controllers 13 of the multiple sub-controllers 8A to 8C and are transmitted to the comprehensive controller 11. The comprehensive controller 11 can obtain, through the individual controllers 13, data of physical quantities detected from the multiple treatment apparatuses 2A to 2C. In one embodiment, the individual controllers 13 may be configured to convert the signals output from the operating sensors 4 into data values and transmit the data values to the comprehensive controller 11. In one embodiment, the comprehensive controller 11 may comprehensively control the operations of the multiple treatment apparatuses 2A to 2C based on the data of physical quantities detected from the multiple treatment apparatuses 2A to 2C.

Examples of the operations of the multiple treatment apparatuses 2A to 2C which are comprehensively controlled by the comprehensive controller 11 include starting operations of the multiple treatment apparatuses 2A to 2C, stopping operations of the multiple treatment apparatuses 2A to 2C, and a backup operation for switching to another treatment apparatus to continue operation when an abnormality has occurred in one of the multiple treatment apparatuses 2A to 2C. More specifically, when the exhaust gas treatment system 1 is the combustion-type exhaust gas treatment system, the starting operations and the stopping operations of the multiple treatment apparatuses 2A to 2C are ignition operations and extinguishing operations of the multiple treatment apparatuses 2A to 2C which are combustion burners. When the exhaust gas treatment system 1 is the catalytic-type exhaust gas treatment system, the starting operations and the stopping operations of the multiple treatment apparatuses 2A to 2C are heating operations and heating-stop operations for reactive materials of the multiple treatment apparatuses 2A to 2C which are catalyst-filled containers. When the exhaust gas treatment system 1 is the plasma-type exhaust gas treatment system, the starting operations and the stopping operations of the multiple treatment apparatuses 2A to 2C are plasma generating operations and plasma-stop operations of the multiple treatment apparatuses 2A to 2C which are plasma generators.

In one embodiment, the comprehensive controller 11 may be configured to regulate amounts of the exhaust gas to be supplied to the multiple treatment apparatuses 2A to 2C by controlling the operations of the operating valves 3 coupled to the multiple treatment apparatuses 2A to 2C via the individual controllers 13, based on an overall amount of the exhaust gas to be treated by the exhaust gas treatment system 1. In one embodiment, the comprehensive controller 11 may be configured to control operation(s) of device(s) (not shown) commonly provided at the multiple treatment apparatuses 2A to 2C. Examples of the device(s) commonly provided at the multiple treatment apparatuses 2A to 2C include cooling-water valves for supplying cooling water flowing through the multiple treatment apparatuses 2A to 2C, exhaust blowers configured to discharge various gases that were discharged from the multiple treatment apparatuses 2A to 2C, and display device(s), alarm lamp(s), or alarm buzzer(s) for indicating any abnormality that occurred in the multiple treatment apparatuses 2A to 2C.

In one embodiment, the individual controller 13 may individually control individual operations required for the operations of the treatment apparatuses 2A to 2C, independently of the comprehensive controller 11. When the exhaust gas treatment system 1 is the combustion-type exhaust gas treatment system, examples of the individual operations required for the operations of the treatment apparatuses 2A to 2C include a valve opening/closing sequence including an operation for safely igniting and an operation for safely extinguishing, and an operation for controlling a timing of generating a spark for the ignition. When the exhaust gas treatment system 1 is the catalytic-type exhaust gas treatment system, an example of the individual operations required for the operations of the treatment apparatuses 2A to 2C is an operation for controlling a heater to maintain a constant temperature in each of the catalyst-filled containers.

In one embodiment, the comprehensive controller 11 is composed of at least one computer. The comprehensive controller 11 includes a memory (not shown) storing programs therein for comprehensively controlling the operations of the multiple treatment apparatuses 2A to 2C, and an arithmetic device (not shown) configured to perform arithmetic operations according to instructions contained in the programs. The memory includes a main memory, such as a random-access memory (RAM), and an auxiliary memory, such as a hard disk drive (HDD) or a solid-state drive (SSD). Examples of the arithmetic device include a central processing unit (CPU) and a graphics processing unit (GPU). However, the specific configuration of the comprehensive controller 11 is not limited to these examples. In one embodiment, the comprehensive controller 11 is a programmable logic controller (PLC), or a control board using microcomputer chip(s), and may be configured to comprehensively control the operations of the multiple treatment apparatuses 2A to 2C based on signals input from outside via a not-shown input device (e.g., a keyboard and a mouse).

The exhaust gas treatment system 1 further includes multiple emergency shut-off valves 16 provided at the multiple of treatment apparatuses 2A to 2C, respectively, and multiple interlock sensors 17 provided at the multiple treatment apparatuses 2A to 2C, respectively.

The emergency shut-off valves 16 are coupled to the corresponding treatment apparatuses 2A to 2C, respectively. The emergency shut-off valves 16 are configured to open and close flow passages of multiple pipes 18 for supplying supply matter, such as fluid (e.g., exhaust gas, fuel, water, etc.), to the corresponding treatment apparatuses 2A to 2C. The emergency shut-off valves 16 are disposed in the pipes 18, respectively, through which the supply matter to be supplied flows to the corresponding treatment apparatuses 2A to 2C. When the emergency shut-off valves 16 are opened, the supply matter is supplied from the pipes 18 to the corresponding treatment apparatuses 2A to 2C. In one embodiment, the emergency shut-off valves 16 may be used in common with the above-described operating valves 3.

Each of the interlock sensors 17 is configured to output a voltage when a corresponding one of the treatment apparatuses 2A to 2C (hereinafter referred to as a corresponding treatment apparatus) is operating normally. Each of the interlock sensors 17 is configured to stop outputting the voltage when an abnormality occurs in the corresponding treatment apparatus. Examples of the interlock sensor 17 include a temperature sensor configured to measure a temperature of the corresponding treatment apparatus, a flame detecting sensor configured to detect a flame in the corresponding treatment apparatus, a water leakage sensor configured to detect a liquid leakage in the corresponding treatment apparatus, and a gas detecting sensor configured to detect a gas leakage in the corresponding treatment apparatus.

For example, the interlock sensor 17 is the temperature sensor and is configured to output a voltage when the temperature of the corresponding treatment apparatus is lower than a threshold value. In another example, the interlock sensor 17 is the flame detecting sensor and is configured to output a voltage when a flame is detected in the corresponding treatment apparatus. In still another example, the interlock sensor 17 is the water leakage sensor and is configured to output a voltage when liquid leakage is not detected in the corresponding treatment apparatus. In still another example, the interlock sensor 17 is the gas detecting sensor and is configured to output a voltage when gas leakage is not detected in the corresponding treatment apparatus.

In this embodiment, the exhaust gas treatment system 1 includes three interlock sensors 17 corresponding to the three treatment apparatuses 2A to 2C, but the exhaust gas treatment system 1 may include one or two interlock sensors 17 corresponding to one or two of the treatment apparatuses 2A to 2C. In one embodiment, the interlock sensors 17 may be used in common with the above-described operating sensors 4.

Each of the multiple sub-controllers 8A to 8C further includes the interlock system 14 configured to perform an interlock operation for closing the emergency shut-off valve 16 when an abnormality occurs in one of the multiple treatment apparatuses 2A to 2C. The emergency shut-off valve 16 closed by the interlock operation is coupled to the treatment apparatus in which the abnormality has occurred. The interlock system 14 is electrically coupled to the emergency shut-off valve 16 and the interlock sensor 17 provided at the corresponding treatment apparatus.

When the emergency shut-off valve 16 is closed, supply of the supply matter from the pipe 18 to the treatment apparatus is stopped. In this way, the interlock operation can stop the supply of the supply matter to the treatment apparatus in which the abnormality has occurred, so that the exhaust gas treatment system 1 can be safely operated. Each of the interlock operations for the treatment apparatuses 2A to 2C in this embodiment is a hardware interlock operation that does not involve software information (programs, data, etc.).

The comprehensive controller 11 of the main controller 7 is electrically coupled to the interlock systems 14 of the multiple sub-controllers 8A to 8C via communication lines 24. The comprehensive controller 11 is configured to comprehensively control the operations of the multiple treatment apparatuses 2A to 2C via the interlock systems 14 of the multiple sub-controllers 8A to 8C. In one embodiment, the comprehensive controller 11 may not be coupled to the interlock systems 14 of the multiple sub-controllers 8A to 8C.

In the exhaust gas treatment system 1 of this embodiment, when the number of treatment apparatuses is increased or decreased, a new sub-controller is added or at least one of the sub-controllers 8A to 8C is removed according to the number of treatment apparatuses, the communication lines 21 and 24 are added or removed, and the connection of the power supply line 20 is changed. Thus, the controller 6 can control the operation of the exhaust gas treatment system 1 in a manner suitable for the number of treatment apparatuses. A power capacity of the power source 10 of the main controller 7 is determined in advance based on the maximum number of treatment apparatuses anticipated.

According to this embodiment, the main controller 7 has the configuration for comprehensively controlling the operations of the multiple treatment apparatuses 2A to 2C. On the other hand, the configurations for individually controlling the operations of the multiple treatment apparatuses 2A to 2C including the interlock operations are included in the multiple sub-controllers 8A to 8C respectively corresponding to the multiple treatment apparatuses 2A to 2C. Therefore, it is not required to change the configuration of the main controller 7 when the number of treatment apparatuses is increased or decreased, or specifications are changed, so that standardization of the main controller 7 can be achieved. As a result, a productivity of the main controller 7 can be improved.

Furthermore, according to this embodiment, the multiple sub-controllers 8A to 8C basically have the same configuration. As a result, an overall productivity of the controller 6 including the main controller 7 and the sub-controllers 8A to 8C can be improved.

In the above-described embodiment, each interlock system 14 is configured to individually perform the interlock operation for the corresponding treatment apparatus, while in one embodiment, the interlock operation for one treatment apparatus may be required to be linked with interlock operations for the other treatment apparatuses. Therefore, in an embodiment described below, when the abnormality has occurred in at least one of the multiple treatment apparatuses 2A to 2C, the interlock systems 14 of the multiple sub-controllers 8A to 8C are configured to be capable of switching between an independent interlock mode for closing only one emergency shut-off valve 16 coupled to the treatment apparatus in which an abnormality has occurred, a linked interlock mode for closing the emergency shut-off valves 16 coupled to at least two of the multiple treatment apparatuses 2A to 2C, and an interlock disabled mode for disabling the interlock operations.

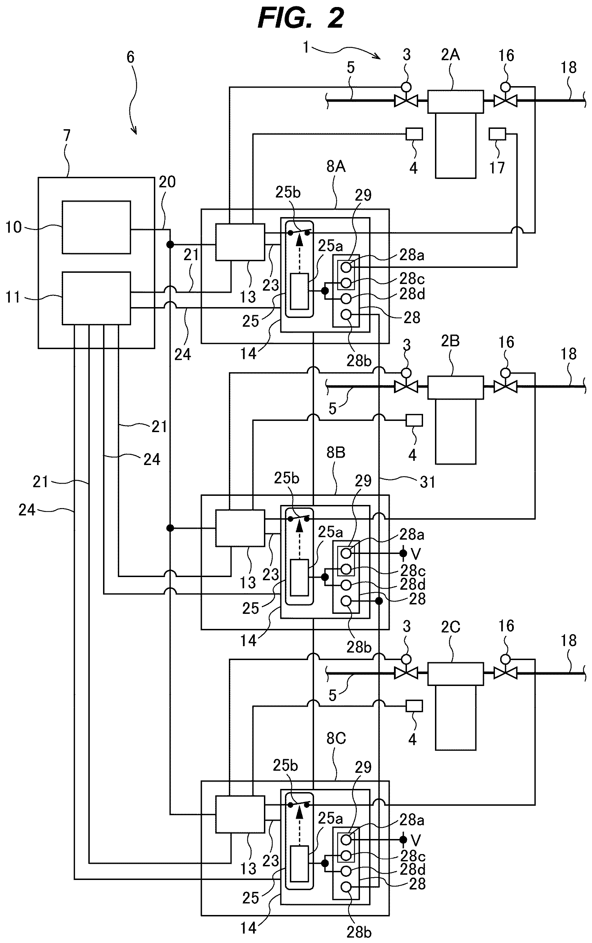

FIG. 2 is a diagram showing another embodiment of the controller 6 including detailed configurations of the interlock systems 14. Configurations and operations of this embodiment, which will not be particularly described, are the same as those of the above-described embodiment, and duplicated descriptions will be omitted.

As shown in FIG. 2, the exhaust gas treatment system 1 of this embodiment includes multiple (three in this embodiment) emergency shut-off valves 16 provided at the multiple treatment apparatuses 2A to 2C, respectively, and an interlock sensor 17 provided at least one treatment apparatus (only the treatment apparatus 2A in this embodiment). The controller 6 includes an interlock synchronization line 31 that electrically couples the multiple sub-controllers 8A to 8C to each other. The individual controllers 13 of the multiple sub-controllers 8A to 8C are electrically coupled to the emergency shut-off valves 16 coupled to the corresponding treatment apparatuses 2A to 2C via the interlock systems 14, respectively. In this embodiment, each of the emergency shut-off valves 16 is configured to be closed when the electrical connection between the individual controller 13 and the emergency shut-off valve 16 is shut off, i.e., when the power is not supplied to the emergency shut-off valve 16. A normally-closed-type valve can be used for such emergency shut-off valve 16.

The interlock system 14 of each of the multiple sub-controllers 8A to 8C includes an individual relay switch 25 disposed between the individual controller 13 and the emergency shut-off valve 16, and a switching device 28 capable of being electrically coupled to the individual relay switch 25. The switching device 28 has a first terminal 28a, a second terminal 28b, a third terminal 28c, and a fourth terminal 28d. The third terminal 28c and the fourth terminal 28d are coupled to each other. In the sub-controller 8A, the first terminal 28a of the switching device 28 is coupled to the interlock sensor 17 provided at the treatment apparatus 2A, the second terminal 28b is coupled to the interlock synchronization line 31, and the third terminal 28c and the fourth terminal 28d are coupled to the individual relay switch 25. In each of the sub-controllers 8B and 8C, the first terminal 28a of the switching device 28 is coupled to a relay power source V configured to apply a voltage to the first terminal 28a, the second terminal 28b is coupled to the interlock synchronization line 31, and the third terminal 28c and the fourth terminal 28d are coupled to the individual relay switch 25.

The interlock sensor 17 is configured to output a voltage when the corresponding treatment apparatus 2A is operating normally, and is configured to not output the voltage when an abnormality occurs in the corresponding treatment apparatus 2A. Each of the individual relay switches 25 has a coil portion 25a and a contact portion 25b. The coil portion 25a is coupled to the third terminal 28c and the fourth terminal 28d. Each of the individual relay switches 25 is configured to receive the voltage output from the interlock sensor 17 to electrically couple the individual controller 13 and the emergency shut-off valve 16 to each other. More specifically, when the voltage output from the interlock sensor 17 is applied to the individual relay switch 25, the individual relay switch 25 is configured to allow a current to flow through the coil portion 25a to close the contact portion 25b to thereby electrically couple the individual controller 13 and the emergency shut-off valve 16 to each other. When the individual controller 13 and the emergency shut-off valve 16 are electrically coupled, an operation of the emergency shut-off valve 16 is controlled by the individual controller 13.

When an abnormality occurs in the treatment apparatus 2A, the interlock sensor 17 stops outputting the voltage. As a result, the current does not flow through the coil 25a of the individual relay switch 25 to open the contact portion 25b, so that the electrical connection between the individual controller 13 and the emergency shut-off valve 16 is shut off. As a result, the emergency shut-off valve 16 is closed.

Each of the switching devices 28 is configured to be capable of switching between an internal electrical path that electrically couples the first terminal 28a and the third terminal 28c with a single short-circuit device 29, an internal electrical path that electrically couples the second terminal 28b and the fourth terminal 28d with a single short-circuit device 29, an internal electrical path that electrically couples the first terminal 28a and the third terminal 28c and electrically couples the second terminal 28b and the fourth terminal 28d with two short-circuit devices 29, and an internal electrical path that does not electrically couples any one of the first terminal 28a to the fourth terminal 28d with the short-circuit device 29. An example of the short-circuit device 29 is a jumper made of a conductive material. The switching device 28 is configured to switch the internal electrical path thereof to thereby be capable of switching between the independent interlock mode for closing only the emergency shut-off valve 16 coupled to the treatment apparatus in which the abnormality has occurred, the linked interlock mode for closing the emergency shut-off valves 16 coupled to at least two of the multiple treatment apparatuses 2A to 2C, and the interlock disabled mode for disabling the interlock operations of the treatment apparatuses 2A to 2C.

In the example shown in FIG. 2, in each of the interlock systems 14, the first terminal 28a and the third terminal 28c of the switching device 28 are electrically coupled by the short-circuit device 29. In such internal electrical path, the interlock sensor 17 provided at the treatment apparatus 2A is electrically coupled to the individual relay switch 25 of the sub-controller 8A via the first terminal 28a and the third terminal 28c of the switching device 28 of the sub-controller 8A. On the other hand, since the second terminal 28b and the fourth terminal 28d of the switching device 28 of the sub-controller 8A are not electrically coupled, the interlock sensor 17 provided at the treatment apparatus 2A is not electrically coupled to the interlock synchronization line 31.

When an abnormality occurred in the treatment apparatus 2A, the interlock sensor 17 provided at the treatment apparatus 2A stops outputting the voltage. Since the voltage is not applied to the individual relay switch 25 of the sub-controller 8A, the contact portion 25b of the individual relay switch 25 of the sub-controller 8A is opened, so that the electrical connection between the individual controller 13 of the sub-controller 8A and the emergency shut-off valve 16 coupled to the treatment apparatus 2A is shut off. Therefore, the emergency shut-off valve 16 coupled to the treatment apparatus 2A is closed, and supply of the supply matter (e.g., fuel) from the pipe 18 is stopped. On the other hand, the interlock sensor 17 provided at the treatment apparatus 2A is not coupled to the interlock synchronization line 31, and the voltage of the relay power source V is applied to each of the individual relay switches 25 of the sub-controllers 8B and 8C via the first terminal 28a and the third terminal 28c.

In each of the interlock systems 14 of the sub-controllers 8B and 8C, the relay power source V is electrically coupled to the individual relay switch 25 via the first terminal 28a and the third terminal 28c of the switching device 28. Since the voltages are applied from the relay power sources V to the individual relay switches 25, the contact portion 25b of the individual relay switch 25 of each of the sub-controllers 8B and 8C remains closed. Therefore, even though the interlock sensor 17 has stopped outputting the voltage, the individual controllers 13 of the sub-controllers 8B and 8C remain electrically coupled to the emergency shut-off valves 16, respectively. In this case, the operations of the emergency shut-off valves 16 coupled to the treatment apparatuses 2B and 2C are controlled by the individual controllers 13 of the sub-controllers 8B and 8C, respectively. In this way, the internal electrical paths of the switching devices 28 shown in FIG. 2 is set to the independent interlock mode for closing only the emergency shut-off valve 16 coupled to the treatment apparatus (the treatment apparatus 2A in this embodiment) in which the abnormality has occurred.

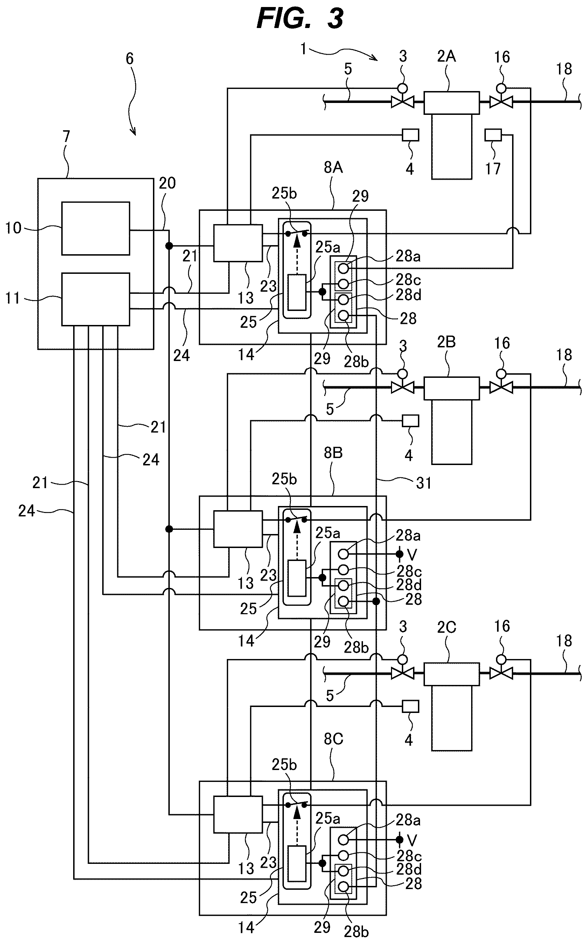

FIG. 3 is a diagram illustrating an example of the internal electrical paths of the switching devices 28 in the controller 6 shown in FIG. 2. In the example shown in FIG. 3, in the interlock system 14 of the sub-controller 8A, the first terminal 28a and the third terminal 28c of the switching device 28 are electrically coupled by a short-circuit device 29, and the second terminal 28b and the fourth terminal 28d are electrically coupled by a short-circuit device 29. In each of the interlock systems 14 of the sub-controllers 8B and 8C, the second terminal 28b and the fourth terminal 28d of the switching device 28 are electrically coupled by a short-circuit device 29, while a short-circuit device 29 is not attached to the first terminal 28a and the third terminal 28c. Therefore, the voltages of the relay power sources V are not applied to the relay switches 25 of the sub-controllers 8B and 8C.

In the internal electrical paths shown in FIG. 3, the interlock sensor 17 provided at the treatment apparatus 2A is coupled to the individual relay switch 25 of the sub-controller 8A via the first terminal 28a and the third terminal 28c of the switching device 28 of the sub-controller 8A. Furthermore, the interlock sensor 17 is coupled to the interlock synchronization line 31 via the second terminal 28b and the fourth terminal 28d of the switching device 28 of the sub-controller 8A. The interlock sensor 17 is coupled to the individual relay switches 25 of the sub-controllers 8B and 8C via the interlock synchronization line 31 and the second terminals 28b and the fourth terminals 28d of the switching devices 28 of the sub-controllers 8B and 8C.

When an abnormality occurred in the treatment apparatus 2A, the interlock sensor 17 provided at the treatment apparatus 2A stops outputting the voltage. Since the voltage is not applied to the individual relay switch 25 of the sub-controller 8A, the contact portion 25b of the individual relay switch 25 of the sub-controller 8A is opened, so that the electrical connection between the individual controller 13 of the sub-controller 8A and the emergency shut-off valve 16 coupled to the treatment apparatus 2A is shut off. As a result, the emergency shut-off valve 16 coupled to the treatment apparatus 2A is closed, and supply of the supply matter (e.g., fuel) from the pipe 18 is stopped.

As shown in FIG. 3, the individual relay switches 25 of the sub-controllers 8B and 8C are not coupled to the relay power sources V, respectively. Therefore, when the voltage output of the interlock sensor 17 provided at the treatment apparatus 2A is stopped, the application of the voltage to the individual relay switches 25 of the sub-controllers 8B and 8C is stopped. As a result, the contact portions 25b of the individual relay switches 25 of the sub-controllers 8B and 8C are opened, so that the electrical connections between the individual controllers 13 of the sub-controllers 8B and 8C and the emergency shut-off valves 16 coupled to the treatment apparatuses 2B and 2C are shut off. Therefore, the emergency shut-off valves 16 coupled to the treatment apparatuses 2B and 2C are closed, and the supply of the supply matter from the pipes 18 to the treatment apparatuses 2B and 2C is stopped.

In this way, the internal electrical paths of the switching device 28 shown in FIG. 3 is set to the linked interlock mode for closing the emergency shut-off valves 16 coupled to at least two of the multiple treatment apparatuses 2A to 2C (all of the treatment apparatuses 2A to 2C in this embodiment) when the abnormality occurs in at least one of the multiple treatment apparatuses 2A to 2C (the treatment apparatus 2A in this embodiment).

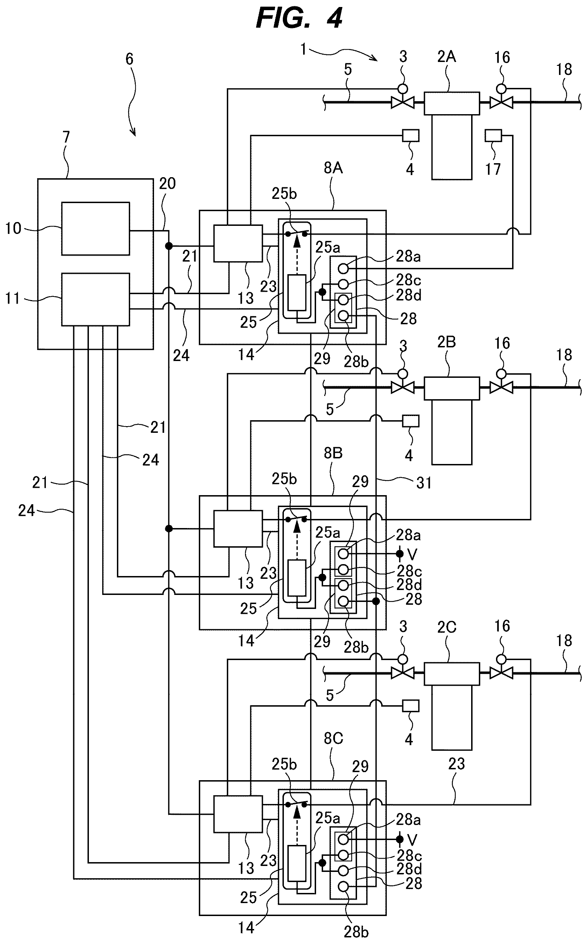

FIG. 4 is a diagram illustrating an example of the internal electrical paths of the switching devices 28 in the controller 6 shown in FIG. 2. In the example shown in FIG. 4, in the interlock system 14 of the sub-controller 8A, the second terminal 28b and the fourth terminal 28d are electrically coupled by a short-circuit device 29. In the interlock system 14 of the sub-controller 8B, the first terminal 28a and the third terminal 28c of the switching device 28 are electrically coupled by a short-circuit device 29, and the second terminal 28b and the fourth terminal 28d are electrically coupled by a short-circuit device 29. In the interlock system 14 of the sub-controller 8C, the first terminal 28a and the third terminal 28c of the switching device 28 are electrically coupled by a short-circuit device 29.

In such internal electrical paths, the interlock sensor 17 provided at the treatment apparatus 2A is not coupled to the individual relay switches 25 of the sub-controllers 8A, 8B, and 8C. On the other hand, the voltage of the relay power source V coupled to the sub-controller 8B is applied to the individual relay switches 25 of the sub-controllers 8A and 8B, and the voltage of the relay power source V coupled to the sub-controller 8C is applied to the individual relay switch 25 of the sub-controller 8C. In other words, even when the voltage output of the interlock sensor 17 is stopped, the voltage is applied to the individual relay switches 25 of the sub-controllers 8A, 8B, and 8C at all times.

According to the internal electrical paths of the switching devices 28 shown in FIG. 4, the electrical connections between the individual controllers 13 of the sub-controllers 8A to 8C and the emergency shut-off valves 16 coupled to the treatment apparatuses 2A to 2C are maintained at all times regardless of detecting of an abnormality by the interlock sensor 17. In other words, the internal electrical paths of the switching devices 28 shown in FIG. 4 are set to the interlock disabled mode for disabling the interlock operations for the treatment apparatuses 2A to 2C.

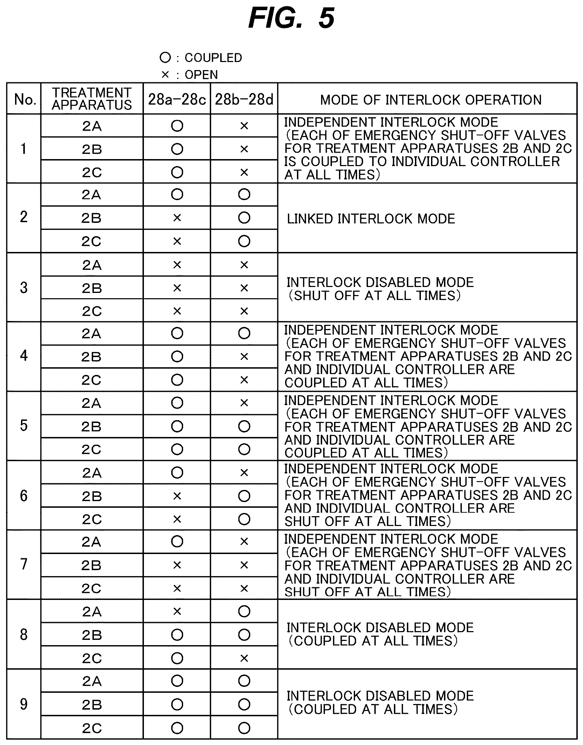

FIG. 5 is a table showing examples of the interlock operations that can be set by the internal electrical paths of the switching devices 28. In the table in FIG. 5, some combinations of the internal electrical paths of the switching devices 28 are shown. In the table in FIG. 5, a column of "28a-28c" indicates whether the short-circuit device 29 is attached to the first terminal 28a and the third terminal 28c of the switching device 28 of each of the sub-controllers 8A to 8C corresponding to the treatment apparatuses 2A to 2C. A code of "∘" in the column of "28a-28c" indicates that the short-circuit device 29 is attached to the first terminal 28a and the third terminal 28c of the switching device 28 to electrically couple the first terminal 28a and the third terminal 28c. A code of "×" in the column of "28a-28c" indicates that the short-circuit device 29 is not attached to the first terminal 28a and the third terminal 28c of the switching device 28 not to electrically couple the first terminal 28a and the third terminal 28c, i.e., an electrically-opened state.

Similarly, a column of "28b-28d" indicates whether the short-circuit device 29 is attached to the second terminal 28b and the fourth terminal 28d of the switching device 28 of each of the sub-controllers 8A to 8C corresponding to the treatment apparatuses 2A to 2C. A code of "∘" in the column of "28b-28d" indicates that the short-circuit device 29 is attached to the second terminal 28b and the fourth terminal 28d of the switching device 28 to electrically couple the second terminal 28b and the fourth terminal 28d. A code of "x" in the column of "28a-28d" indicates that the short-circuit device 29 is not attached to the second terminal 28b and the fourth terminal 28d of the switching device 28 not to electrically couple the second terminal 28b and the fourth terminal 28d, i.e., an electrically-opened state.

No. 1 is the internal electrical paths described with reference to FIG. 2, and No. 2 is the internal electrical paths described with reference to FIG. 3.

In No. 3, the first terminals 28a, the second terminals 28b, the third terminals 28c, and the fourth terminals 28d of all of the sub-controllers 8A, 8B, and 8C are not electrically coupled, and all of the emergency shut-off valves 16 coupled to the treatment apparatuses 2A, 2B, and 2C are closed at all times (i.e., the interlock disabled mode).

In No. 4, the first terminal 28a and the third terminal 28c of the switching device 28 of the sub-controller 8A are electrically coupled by the short-circuit device 29, and the second terminal 28b and the fourth terminal 28d of the switching device 28 of the sub-controller 8A are electrically coupled by the short-circuit device 29. The first terminal 28a and the third terminal 28c of each of the switching devices 28 of the sub-controllers 8B and 8C are electrically coupled by the short-circuit device 29, and the second terminal 28b and the fourth terminal 28d of each of the switching devices 28 of the sub-controllers 8B and 8C are not electrically coupled. Such internal electrical paths provide the independent interlock mode for closing only the emergency shut-off valve 16 coupled to the treatment apparatus (the treatment apparatus 2A in this embodiment) in which an abnormality has occurred. The emergency shut-off valves 16 for the treatment apparatuses 2B and 2C are electrically coupled to the individual controllers 13 of the sub-controllers 8B and 8C at all times, so that the operations of the emergency shut-off valves 16 coupled to the treatment apparatuses 2B and 2C are controlled by the individual controllers 13 of the sub-controllers 8B and 8C, respectively.

In No. 5, the first terminal 28a and the third terminal 28c of the switching device 28 of the sub-controller 8A are electrically coupled by the short-circuit device 29, while the second terminal 28b and the fourth terminal 28d of the switching device 28 of the sub-controller 8A are not electrically coupled. The first terminal 28a and the third terminal 28c of each of the switching devices 28 of the sub-controllers 8B and 8C are electrically coupled by the short-circuit device 29, and the second terminal 28b and the fourth terminal 28d of each of the switching devices 28 of the sub-controllers 8B and 8C are electrically coupled by the short-circuit device 29. Such internal electrical paths provide the independent interlock mode for closing only the emergency shut-off valve 16 coupled to the treatment apparatus (the treatment apparatus 2A in this embodiment) in which an abnormality has occurred. The emergency shut-off valves 16 for the treatment apparatuses 2B and 2C are electrically coupled to the individual controllers 13 of the sub-controllers 8B and 8C at all times, so that the operations of the emergency shut-off valves 16 coupled to the treatment apparatuses 2B and 2C are controlled by the individual controllers 13 of the sub-controllers 8B and 8C, respectively.

In No. 6, the first terminal 28a and the third terminal 28c of the switching device 28 of the sub-controller 8A are electrically coupled by the short-circuit device 29, while the second terminal 28b and the fourth terminal 28d of the switching device 28 of the sub-controller 8A are not electrically coupled. The first terminal 28a and the third terminal 28c of each of the switching devices 28 of the sub-controllers 8B and 8C are not electrically coupled, while the second terminal 28b and the fourth terminal 28d of each of the switching devices 28 of the sub-controllers 8B and 8C are electrically coupled by the short-circuit device 29. Such internal electrical paths provide the independent interlock mode for closing only the emergency shut-off valve 16 coupled to the treatment apparatus (the treatment apparatus 2A in this embodiment) in which an abnormality has occurred. Since the voltage is not applied to the individual relay switches 25 of the interlock systems 14 of the sub-controllers 8B and 8C, the electrical connections between the emergency shut-off valves 16 for the treatment apparatuses 2B and 2C and the individual controllers 13 of the sub-controllers 8B and 8C are shut off at all times.

In No. 7, the first terminal 28a and the third terminal 28c of the switching device 28 of the sub-controller 8A are electrically coupled by the short-circuit device 29, while the second terminal 28b and the fourth terminal 28d of the switching device 28 of the sub-controller 8A are not electrically coupled. None of the first terminals 28a to the fourth terminal 28d of each of the switching devices 28 of the sub-controllers 8B and 8C are electrically coupled by the short-circuit device 29. Such internal electrical paths provide the independent interlock mode for closing only the emergency shut-off valve 16 coupled to the treatment apparatus (the treatment apparatus 2A in this embodiment) in which an abnormality has occurred. Since the voltage is not applied to the individual relay switches 25 of the interlock systems 14 of the sub-controllers 8B and 8C, the electrical connections between the emergency shut-off valves 16 for the treatment apparatuses 2B and 2C and the individual controllers 13 of the sub-controllers 8B and 8C are shut off at all times.

No. 8 is the internal electrical paths described with reference to FIG. 4.

In No. 9, the first terminal 28a and the third terminal 28c of each of the switching devices 28 of the sub-controllers 8A to 8C are electrically coupled by the short-circuit device 29, and the second terminal 28b and the fourth terminal 28d of each of the switching devices 28 of the sub-controllers 8A to 8C are electrically coupled by the short-circuit device 29. Such internal electrical paths provide the interlock disabled mode for disabling the interlock operations. In other words, the individual relay switches 25 of the interlock systems 14 of the sub-controllers 8A, 8B, and 8C are electrically coupled to the relay power sources V. Therefore, the emergency shut-off valves 16 for the treatment apparatuses 2A to 2C are electrically coupled to the individual controllers 13 of the sub-controllers 8A to 8C at all times.

According to this embodiment, the interlock operations for the treatment apparatuses 2A to 2C can be switched by switching the internal electrical paths of the switching devices 28 of the sub-controllers 8A to 8B without changing the configurations of the main controller 7 and the sub-controllers 8A to 8C. Therefore, the overall productivity of the controller 6 including the main controller 7 and the sub-controllers 8A to 8C can be improved.

In this embodiment, the interlock sensor 17 is provided only for the treatment apparatus 2A, but the arrangement of the interlock sensor(s) 17 is not limited to this embodiment as long as the interlock sensor 17 is provided for least one of the treatment apparatuses 2A to 2C. For example, the interlock sensor 17 may be provided for the treatment apparatus 2B or the treatment apparatus 2C. In another example, the interlock sensors 17 may be provided for all of the treatment apparatuses 2A to 2C, respectively. In these cases also, the controller 6 can switch the interlock operations for the treatment apparatuses 2A to 2C by switching the internal electrical paths of the switching devices 28 of the sub-controllers 8A to 8B according to the arrangement of the interlock sensor(s) 17.

In the above-described embodiment, the interlock systems 14 of the multiple sub-controllers 8A to 8C are configured to close the emergency shut-off valves 16 coupled to the interlock systems 14, respectively. However, depending on a type of the interlock sensor 17, all of the valves (including the operating valves 3 and the emergency shut-off valves 16) provided at the treatment apparatuses 2A to 2C may be required to be closed to ensure a safety of the exhaust gas treatment system 1. For example, if the interlock sensor 17 is a water leakage sensor or a gas leakage detecting sensor and such a sensor detects a water leakage or a gas leakage, the operations of all of the treatment apparatuses 2A to 2C may be required to be stopped. Therefore, when an abnormality is detected by the water leakage sensor or the gas leakage detecting sensor provided at one of the multiple treatment apparatuses 2A to 2C, all of the valves (including the operating valves 3 and emergency shut-off valves 16) provided at all of the treatment apparatuses 2A to 2C may be required to be closed.

Thus, in an embodiment described below, the interlock systems 14 of the multiple sub-controllers 8A to 8C are configured to be capable of setting to a power-source interlock mode for stopping supply of the electric power to all of the sub-controllers 8A to 8C to thereby close all of the valves (including the operating valves 3 and the emergency shut-off valves 16) provided at the treatment apparatuses 2A to 2C when an abnormality occurs in at least one of the multiple treatment apparatuses 2A to 2C.

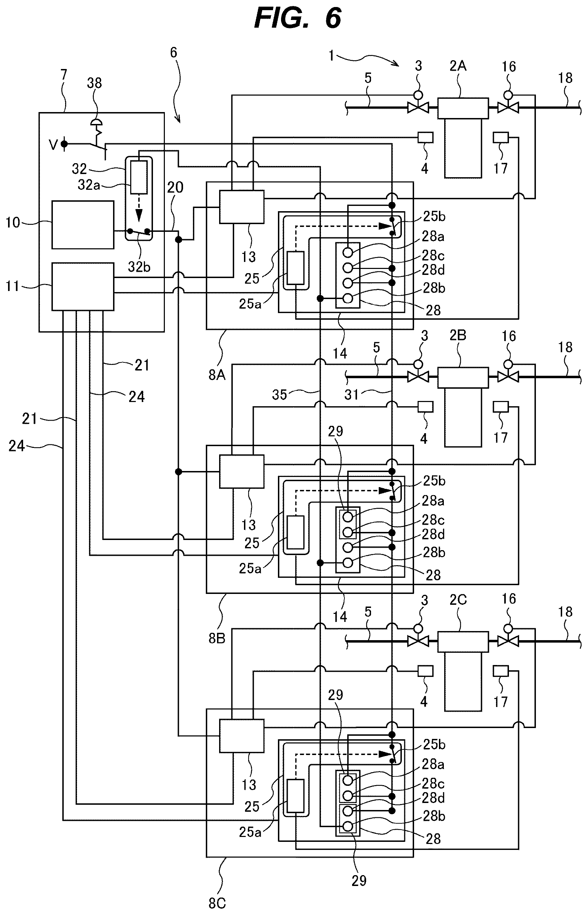

FIG. 6 is a diagram showing still another embodiment of the controller 6 including the detailed configurations of the interlock systems 14. Configurations and operations of this embodiment, which will not be particularly described, are the same as those of the embodiments described with reference to FIGS. 1 to 4, and duplicated descriptions will be omitted.

As shown in FIG. 6, the exhaust gas treatment system 1 of this embodiment includes multiple (three in this embodiment) emergency shut-off valves 16 provided at the multiple treatment apparatuses 2A to 2C, respectively, and interlock sensor(s) 17 provided for at least one treatment apparatus. In this embodiment, multiple interlock sensors 17 are provided at all of the treatment apparatuses 2A to 2C. The multiple interlock sensors 17 are coupled to multiple individual relay switches 25 of the sub-controllers 8A to 8C, respectively. These multiple individual relay switches 25 and the first terminals 28a, the third terminals 28c, and the fourth terminals 28d of the multiple switching devices 28 of the sub-controllers 8A to 8C are coupled to the interlock synchronization line 31. The multiple emergency shut-off valves 16 are coupled to the individual controllers 13 of the sub-controllers 8A to 8C, respectively.

The main controller 7 further includes a power-source relay switch 32 coupled to the power source 10. The power-source relay switch 32 is coupled to the power supply line 20 extending from the power source 10, and is disposed upstream of the individual controllers 13 of the sub-controllers 8A to 8C.

The controller 6 further includes a power-source interlock synchronization line 35 that electrically couples the multiple sub-controllers 8A to 8C each other. The power-source interlock synchronization line 35 is coupled to the power-source relay switch 32 of the main controller 7. The power-source relay switch 32 is electrically coupled to the individual relay switches 25 via the power-source interlock synchronization line 35, at least one of the multiple switching devices 28 of the sub-controllers 8A to 8C, and the interlock synchronization line 31. The interlock synchronization line 31 is coupled to a relay power source V.

The power-source relay switch 32 has a coil portion 32a and a contact portion 32b. When a current flows through the coil portion 32a, the contact portion 32b is closed. The power-source relay switch 32 is configured to shut off the electrical connections between the power source 10 of the main controller 7 and the individual controllers 13 of the sub-controllers 8A to 8C when an interlock sensor 17 provided at any of the treatment apparatuses 2A to 2C detects an abnormality. More specifically, when the interlock sensor 17 provided at any of the treatment apparatuses 2A to 2C detects the abnormality, the interlock sensor 17 stops outputting the voltage. As a result, the individual relay switch 25 coupled to the interlock sensor 17 is opened to thereby stop the application of the voltage from the relay power source V to the power-source relay switch 32. Since the current supply to the coil portion 32a of the power-source relay switch 32 is stopped, the contact portion 32b is opened, so that the electrical connections between the power source 10 of the main controller 7 and the individual controllers 13 of the sub-controllers 8A to 8C are shut off.

The power-source relay switch 32 is configured to electrically couple the power source 10 of the controller 7 to the individual controllers 13 of the sub-controllers 8A to 8C when the voltage is output from the interlock sensor 17 (i.e., when the treatment apparatuses 2A to 2C are operating normally). More specifically, when an abnormality does not occur in each of the treatment apparatuses 2A to 2C, the interlock sensor 17 applies the voltage to the individual relay switch 25. Since the individual relay switch 25 is closed, the voltage of the relay power source V is applied to the power-source relay switch 32 via the interlock synchronization line 31, the power-source interlock synchronization line 35, and at least one of the multiple switching devices 28 of the sub-controllers 8A to 8C. As a result, the current is supplied to the coil portion 32a of the power-source relay switch 32 to close the contact portion 32b, so that the power source 10 of the main controller 7 is electrically coupled to the individual controllers 13 of the sub-controllers 8A to 8C. When the power source 10 of the controller 7 is electrically coupled to the sub-controllers 8A to 8C, the operations of the emergency shut-off valves 16 are controlled by the individual controllers 13 of the sub-controllers 8A to 8C, respectively.

The main controller 7 further includes the above-described relay power source V coupled to the interlock system 14 of the sub-controller 8A and configured to apply the voltage to the interlock system 14, and a forced shut-off switch 38 disposed between the relay power source V and the interlock system 14 of the sub-controller 8A. The relay power source V and the forced shut-off switch 38 are coupled to the interlock synchronization line 31. When the forced shut-off switch 38 is opened, the voltage of the relay power source V is not applied to the power-source relay switch 32. As a result, the power-source relay switch 32 is opened, so that the electrical connections between the power source 10 of the main controller 7 and the individual controllers 13 of the sub-controllers 8A to 8C are shut off.

In this embodiment, the individual relay switches 25 of the sub-controllers 8A to 8C are coupled to the interlock sensors 17 provided at the treatment apparatuses 2A to 2C and are coupled to the interlock synchronization line 31. In each of the switching devices 28 of the sub-controllers 8C to 8C, the first terminal 28a, the third terminal 28c, and the fourth terminal 28d are coupled to the interlock synchronization line 31, and the second terminal 28b is coupled to the power-source interlock synchronization line 35. The contact portion 25b of the individual relay switch 25 is disposed between the first terminal 28a and the third terminal 28c.

In this embodiment, the emergency shut-off valves 16 coupled to the treatment apparatuses 2A to 2C are coupled to the individual controllers 13 of the corresponding sub-controllers 8A to 8C, respectively. When the treatment apparatuses 2A to 2C are operating normally and the second terminal 28b and the fourth terminal 28d of the switching device 28 of the sub-controller 8C are electrically coupled by the short-circuit device 29, the voltage of the relay power source V of the main controller 7 is applied to the power-source relay switch 32 of the main controller 7 via the interlock synchronization line 31 and the power-source interlock synchronization line 35. The power-source relay switch 32 electrically couples the power source 10 of the main controller 7 to the individual controllers 13 of the sub-controllers 8A to 8C to supply the electric power from the power source 10 to the individual controllers 13 of the sub-controllers 8A to 8C. Therefore, all of the valves (including the operating valves 3 and emergency shut-off valves 16) provided at the treatment apparatuses 2A to 2C are opened.

In the example shown in FIG. 6, none of the first terminal 28a to the fourth terminal 28d of the switching device 28 of the sub-controller 8A are electrically coupled by the short-circuit device 29. The first terminal 28a and the third terminal 28c of the switching device 28 of the sub-controller 8B are electrically coupled by the short-circuit device 29. The first terminal 28a and the third terminal 28c of the switching device 28 of the sub-controller 8C are electrically coupled by the short-circuit device 29, and the second terminal 28b and the fourth terminal 28d of the switching device 28 of the sub-controller 8C are electrically coupled by the short-circuit device 29. In such internal electrical paths of the switching devices 28, the individual relay switch 25 of the sub-controller 8A is opened when an abnormality occurs only in the interlock sensor 17 provided at the treatment apparatus 2A. As a result, the application of the voltage from the relay power source V to the power-source relay switch 32 of the main controller 7 is stopped. The power-source relay switch 32 shuts off the electrical connections between the power source 10 of the main controller 7 and the individual controllers 13 of the sub-controllers 8A to 8C. Therefore, the supply of the electric power from the power source 10 to all of the sub-controllers 8A to 8C is stopped, so that all of the valves (including the operating valves 3 and the emergency shut-off valves 16) provided at the treatment apparatuses 2A to 2C are closed. In this way, when the abnormality occurs in the treatment apparatus 2A, the power-source interlock mode for stopping the supply of power from the power source 10 is performed to thereby stop the operations of all of the treatment apparatuses 2A to 2C.

When the forced shut-off switch 38 of the main controller 7 is opened, the electrical connection between the relay power source V and the interlock synchronization line 31 is forcibly shut off. Therefore, the voltage is not applied from the relay power source V to the power-source relay switch 32, so that the power-source relay switch 32 is opened regardless of the internal electrical paths of the switching devices 28 of the sub-controllers 8A to 8C. As a result, the supply of the electric power from the power source 10 to all of the sub-controllers 8A to 8C is stopped, so that the operations of all of the treatment apparatuses 2A to 2C can be stopped.

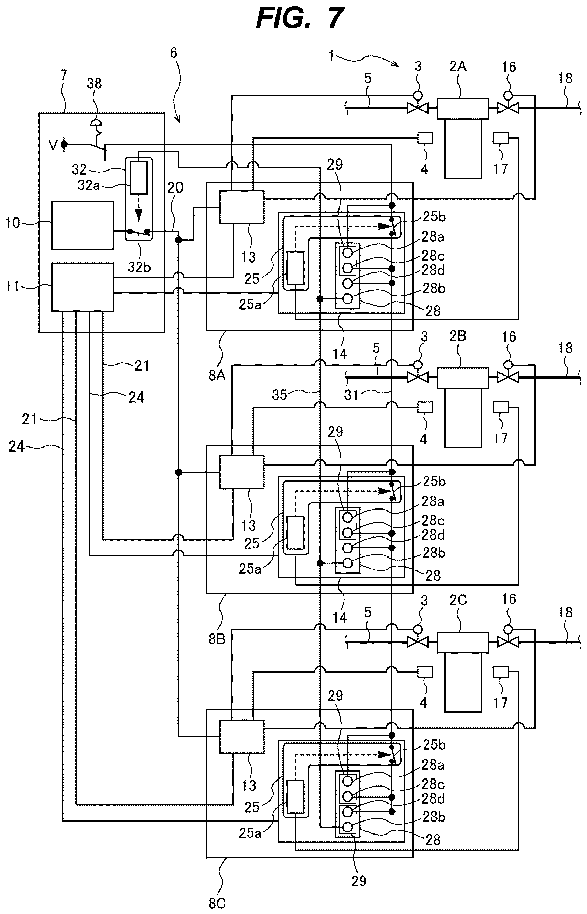

FIG. 7 is a diagram illustrating another example of the internal electrical paths of the switching devices 28 in the controller 6 shown in FIG. 6. In the example shown in FIG. 7, the first terminal 28a and the third terminal 28c of each of the switching devices 28 of the sub-controllers 8A and 8B are electrically coupled by the short-circuit device 29. The first terminal 28a and the third terminal 28c of the switching device 28 of the sub-controller 8C are electrically coupled by the short-circuit device 29, and the second terminal 28b and the fourth terminal 28d of the switching device 28 of the sub-controller 8C are electrically coupled by the short-circuit device 29. In such internal electrical paths of the switching devices 28, the individual relay switch 25 coupled to the interlock sensor 17 provided at the treatment apparatus in which an abnormality has occurred is opened when the abnormality occurs in any of the treatment apparatuses 2A to 2C.

However, the voltage of the relay power source V of the main controller 7 is applied to the interlock synchronization line 31 via the first terminals 28a and the third terminals 28c of the switching devices 28 of the sub-controllers 8A to 8C. Furthermore, the voltage is applied to the power-source relay switch 32 of the main controller 7 via the second terminal 28b and the fourth terminal 28d of the switching device 28 of the sub-controller 8C and the power-source interlock synchronization line 35. Therefore, the power-source relay switch 32 electrically couples the power source 10 of the main controller 7 to the individual controllers 13 of the sub-controllers 8A to 8C at all times, so that the power is supplied from the power source 10 to the individual controllers 13 of the sub-controllers 8A to 8C. As a result, the emergency shut-off valves 16 coupled to the treatment apparatuses 2A to 2C are opened at all times. Therefore, such internal electrical paths provide the interlock disabled mode for disabling the interlock operations.

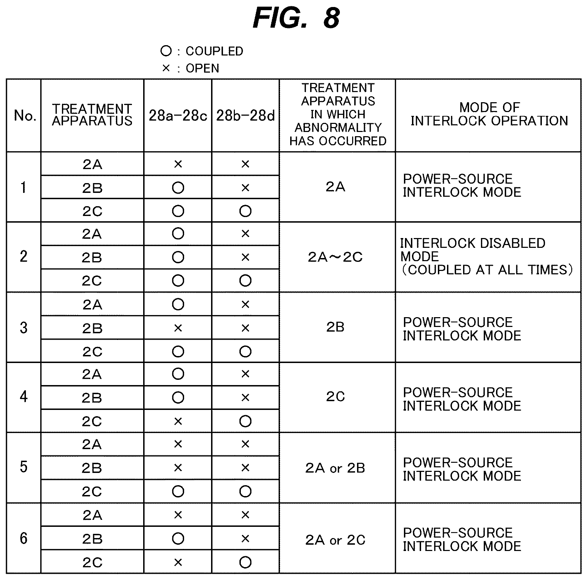

FIG. 8 is a table showing examples of modes of the power-source interlock operation set by the internal electrical paths of the switching devices 28. In the table in FIG. 8, some combinations of the internal electrical paths of the switching devices 28 are shown. A column of "28a-28c" and a column of "28b-28d" in the table in FIG. 8 are the same as those in the table in FIG. 5. No. 1 is the internal electrical paths described with reference to FIG. 6, and No. 2 is the internal electrical paths described with reference to FIG. 7.

In No. 3, the first terminal 28a and the third terminal 28c of the switching device 28 of the sub-controller 8A are electrically coupled by the short-circuit device 29. None of the first terminals 28a to the fourth terminal 28d of the switching device 28 of the sub-controller 8B are electrically coupled by the short-circuit device 29. The first terminal 28a and the third terminal 28c of the switching device 28 of the sub-controller 8C are electrically coupled by the short-circuit device 29, and the second terminal 28b and the fourth terminal 28d of the switching device 28 of the sub-controller 8C are electrically coupled by the short-circuit device 29. Such internal electrical paths provide the power-source interlock mode for stopping the supply of the power to all of the sub-controllers 8A to 8C to thereby stop the operations of all of the treatment apparatuses 2A to 2C when an abnormality occurs in the treatment apparatus 2B.

In No. 4, the first terminal 28a and the third terminal 28c of the switching device 28 of each of the sub-controllers 8A and 8B are electrically coupled by the short-circuit device 29. The second terminal 28b and the fourth terminal 28d of the switching device 28 of the sub-controller 8C are electrically coupled by the short-circuit device 29. Such internal electrical paths provide the power-source interlock mode for stopping the supply of the power to all of the sub-controllers 8A to 8C to thereby stop the operations of all of the treatment apparatuses 2A to 2C when an abnormality occurs in the treatment apparatus 2C.

In No. 5, the first terminal 28a to the fourth terminal 28d of the switching device 28 of each of the sub-controllers 8A and 8B are not electrically coupled by the short-circuit device 29. The first terminal 28a and the third terminal 28c of the switching device 28 of the sub-controller 8C are electrically coupled by the short-circuit device 29, and the second terminal 28b and the fourth terminal 28d of the switching device 28 of the sub-controller 8C are electrically coupled by the short-circuit device 29. Such internal electrical paths provide the power-source interlock mode for stopping the supply of the power to all of the sub-controllers 8A to 8C to thereby stop the operations of all of the treatment apparatuses 2A to 2C when an abnormality occurs in at least one of the treatment apparatuses 2A and 2B.

In No. 6, none of the first terminal 28a to the fourth terminal 28d of the switching device 28 of the sub-controller 8A are electrically coupled by the short-circuit device 29. The first terminal 28a and the third terminal 28c of the switching device 28 of the sub-controller 8B are electrically coupled by the short-circuit device 29. The second terminal 28b and the fourth terminal 28d of the switching device 28 of the sub-controller 8C are electrically coupled by the short-circuit device 29. Such internal electrical paths provide the power-source interlock mode for stopping the supply of the power to all of the sub-controllers 8A to 8C to thereby stop the operations of all of the treatment apparatuses 2A to 2C when an abnormality occurs in at least one of the treatment apparatuses 2A and 2C.

According to this embodiment, the power-source interlock operations for the treatment apparatuses 2A to 2C can be switched by switching the internal electrical paths of the switching devices 28 of the sub-controllers 8A to 8B without changing the configurations of the main controller 7 and the sub-controllers 8A to 8C. Therefore, the overall productivity of the controller 6 including the main controller 7 and the sub-controllers 8A to 8C can be improved.

In this embodiment, the interlock sensors 17 are provided at all of the treatment apparatuses 2A to 2C, respectively, but the arrangement of the interlock sensor(s) 17 is not limited to this embodiment as long as the interlock sensor 17 is provided at least one of the treatment apparatuses 2A to 2C. The controller 6 can switch the power-source interlock operations for the treatment apparatuses 2A to 2C by switching the internal electrical paths of the switching devices 28 of the sub-controllers 8A to 8B according to the arrangement of the interlock sensor(s) 17.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The present invention is applicable to a controller and a controlling method for controlling an operation of an exhaust gas treatment system having multiple treatment apparatuses.

### Reference Signs List

- 1: exhaust gas treatment system
- 2A, 2B, 2C: treatment apparatus
- 3: operating valve (device)
- 4: operating sensor (device)
- 5: pipe
- 6: controller
- 7: main controller
- 8A, 8B, 8C: sub-controller
- 10: power source
- 11: comprehensive controller
- 13: individual controller
- 14: interlock system
- 16: emergency shut-off valve
- 17: interlock sensor
- 18: pipe
- 20: power supply line
- 21: communication line
- 23: power supply line
- 24: communication line
- 25: relay switch
- 25a: coil portion
- 25b: contact portion
- 28: switching device
- 28a: first terminal
- 28b: second terminal
- 28c: third terminal
- 28d: fourth terminal
- 29: short-circuit device
- 31: interlock synchronization line
- 32: power-source relay switch
- 32a: coil portion
- 32b: contact portion
- 35: power-source interlock synchronization line
- 38: forced shut-off switch

## Claims

1. A controller for controlling an operation of an exhaust gas treatment system having multiple treatment apparatuses, the controller comprising:
multiple sub-controllers corresponding to the multiple treatment apparatuses and configured to individually control operations of the multiple treatment apparatuses; and
a main controller electrically coupled to the multiple sub-controllers,
wherein the main controller includes:
a power source configured to supply electric power to the multiple sub-controllers; and
a comprehensive controller configured to comprehensively control the operations of the multiple treatment apparatuses, and
each of the multiple sub-controllers includes an individual controller electrically coupled to a device configured to operate a corresponding treatment apparatus.

2. The controller according to claim 1, wherein the device comprises an operating valve coupled to the corresponding treatment apparatus.

3. The controller according to claim 1, wherein the device comprises an operating sensor configured to detect a physical quantity in the corresponding treatment apparatus and output a signal representing the physical quantity.

4. The controller according to claim 1, wherein
each of the multiple sub-controllers further includes an interlock system configured to perform an interlock operation for closing an emergency shut-off valve when an abnormality occurs in at least one treatment apparatus of the multiple treatment apparatuses, the emergency shut-off valve being coupled to the treatment apparatus in which the abnormality has occurred,
the interlock system is electrically coupled to the emergency shut-off valve, and an interlock sensor provided at the at least one treatment apparatus, and
the interlock system is configured to close the emergency shut-off valve when the interlock sensor detects that the abnormality has occurred in the at least one treatment apparatus.

5. The controller according to claim 4, wherein
the individual controller is electrically coupled to the emergency shut-off valve via the interlock system,
the emergency shut-off valve is configured to be closed when an electrical connection between the individual controller and the emergency shut-off valve is shut off,
the interlock system includes an individual relay switch disposed between the individual controller and the emergency shut-off valve, and
the individual relay switch is configured to shut off the electrical connection between the individual controller and the emergency shut-off valve when the interlock sensor detects that the abnormality has occurred in the at least one treatment apparatus.

6. The controller according to claim 5, wherein
the controller further includes an interlock synchronization line that electrically couples the multiple sub-controllers to each other,
the interlock system further includes a switching device capable of being electrically coupled to the interlock synchronization line and the individual relay switch, and
the switching device is configured to switch an internal electrical path thereof to thereby switch between an independent interlock mode for closing only the emergency shut-off valve coupled to the treatment apparatus in which the abnormality has occurred, a linked interlock mode for closing emergency shut-off valves coupled to at least two treatment apparatuses of the multiple treatment apparatuses, and an interlock disabled mode for disabling the interlock operation.

7. The controller according to any one of claims 1 to 3, wherein
the main controller further includes a power-source relay switch coupled to the power source,
each of the multiple sub-controllers includes an individual relay switch coupled to an interlock sensor provided at least one treatment apparatus of the multiple treatment apparatuses,
the power-source relay switch is electrically coupled to the individual relay switch, and
the power-source relay switch is configured to shut off supply of the electric power from the power source to the multiple sub-controllers to stop operations of the multiple treatment apparatuses when the interlock sensor detects that the abnormality has occurred in the at least one treatment apparatus.

8. A controlling method of controlling an operation of an exhaust gas treatment system having multiple treatment apparatuses, the method comprising:
individually controlling operations of the multiple treatment apparatuses by multiple sub-controllers corresponding to the multiple treatment apparatuses;
supplying electric power to the multiple sub-controllers from a power source of a main controller electrically coupled to the multiple sub-controllers; and
comprehensively controlling the operations of the multiple treatment apparatuses by the main controller.

9. The controlling method according to claim 8, wherein individually controlling the operations of the multiple treatment apparatuses comprises controlling operations of operating valves coupled to the corresponding treatment apparatuses.

10. The controlling method according to claim 8, further comprising:
performing an interlock operation for closing an emergency shut-off valve by at least one sub-controller of the multiple sub-controllers when an interlock sensor detects that an abnormality has occurred in at least one treatment apparatus of the multiple treatment apparatuses, the emergency shut-off valve being coupled to the treatment apparatus in which the abnormality has occurred.

11. The controlling method according to claim 10, further comprising:
switching an internal electrical path of the multiple sub-controllers to thereby switch between an independent interlock mode for closing only the emergency shut-off valve coupled to the treatment apparatus in which the abnormality has occurred, a linked interlock mode for closing emergency shut-off valves coupled to at least two treatment apparatuses of the multiple treatment apparatuses, and an interlock disabled mode for disabling the interlock operation.

12. The controlling method according to claim 8, further comprising:
shutting off supply of the electric power from the power source to the multiple sub-controllers to stop operations of the multiple treatment apparatuses when the interlock sensor detects that an abnormality has occurred in at least one treatment apparatus of the multiple treatment apparatuses.
